# EUROPEAN PATENT APPLICATION

(11) **EP 4 838 236 A1**
(43) Date of publication of application: **11.11.2026**
(21) Application number: 26174124.3
(22) Date of filing: 23.04.2026
(51) Int. Cl.: G01R 31/34, G01R 19/00, G01R 19/25, H02P 29/024, H02P 23/14

(54) **APPARATUSES AND METHODS FOR DETECTING BROKEN ROTOR BAR FAULTS IN INDUCTION MOTORS**

(30) Priority: 09.05.2025 US 202519203559
(71) Applicant: ABB Schweiz AG, 5400 Baden (CH)
(72) Inventor: GONG, Huangjie, Raleigh, 27607 (US); CHOOBINEH, Moein, Cary, 27519 (US); FADDEL MOHAMED, Samy, Clayton, 27527 (US)
(74) Representative: Maiwald GmbH

(57) **Abstract**

Apparatuses may include an induction motor, a three-phase electrical current input, a sensor for sensing electrical current input values, and a processor. The processor may apply a Park transform to the sensed electrical current values to form Park circles, determine their thicknesses, and identify a broken rotor bar fault when the thickness exceeds a predetermined threshold and/or trends upward. Various other related apparatuses, systems, and methods are also disclosed.

## Description

### BACKGROUND

Electrical induction motors are used within various industrial processes worldwide, playing a pivotal role in driving machinery and equipment. The efficient operation of these motors is crucial not only for productivity but also for reducing energy consumption and associated costs. Identification of faults in induction motors can help maintenance teams timely replace and/or repair motors that have broken components (e.g., rotor bars) or that are otherwise not running as designed.

### BRIEF DESCRIPTION OF THE DRAWINGS

The accompanying drawings illustrate a number of example embodiments and are a part of the specification. Together with the following description, these drawings demonstrate and explain various principles of the present disclosure.
FIG. 1 is a block diagram illustrating an apparatus for detecting broken rotor bar faults in induction motors, according to at least one embodiment of the present disclosure.
FIG. 2 is a schematic block diagram illustrating a sequence of data batches processed by a broken rotor bar fault detection module, according to at least one embodiment of the present disclosure.
FIG. 3 is a diagram illustrating the transformation of three-phase current data into a Park circle using a Park transform, according to at least one embodiment of the present disclosure.
FIG. 4A is a plot illustrating a first Park circle generated during healthy operation of an induction motor, according to at least one embodiment of the present disclosure.
FIG. 4B is a plot illustrating a second Park circle generated during faulty operation of an induction motor, according to at least one embodiment of the present disclosure.
FIG. 5 is a plot illustrating a Park circle and an angular segment used for detecting broken rotor bar faults in induction motors, according to at least one embodiment of the present disclosure.
FIG. 6 is a detailed plot illustrating the angular segment of FIG. 5, taken from dashed box A of FIG. 5, and the points with maximum and minimum radius within the angular segment, according to at least one embodiment of the present disclosure.
FIG. 7 is a flow chart diagram illustrating a method for determining a thickness of a Park circle obtained from operation of an induction motor, according to at least one embodiment of the present disclosure.
FIG. 8 is a flow diagram illustrating a method for detecting broken rotor bar faults in induction motors, according to at least one embodiment of the present disclosure.
FIG. 9 is a flow diagram illustrating a method for detecting broken rotor bar faults in induction motors, according to at least one additional embodiment of the present disclosure.

Throughout the drawings, identical reference characters and descriptions indicate similar, but not necessarily identical, elements. While the example embodiments described herein are susceptible to various modifications and alternative forms, specific embodiments have been shown by way of example in the drawings and will be described in detail herein. However, the example embodiments described herein are not intended to be limited to the particular forms disclosed. Rather, the present disclosure covers all modifications, equivalents, and alternatives falling within the scope of the appended claims.

### DETAILED DESCRIPTION OF EXAMPLE EMBODIMENTS

Induction motors are widely used in various industrial applications due to their robustness, reliability, and cost-effectiveness. However, these motors are susceptible to faults, such as broken rotors, which can significantly impact their performance and efficiency. Detecting such faults promptly is important to prevent further damage and maintain operational efficiency. Traditional methods for detecting broken rotor bar faults often rely on additional sensors or complex data analysis techniques, which can be costly and difficult to implement in existing systems.

Previous solutions for detecting broken rotor bar faults typically involve the use of advanced sensors to measure parameters like temperature, vibration, or magnetic fields. These methods require additional hardware, which may not be readily available in all systems, leading to increased costs and complexity. Furthermore, some techniques rely on frequency domain analysis using Fast Fourier Transform (FFT), which demands significant computational resources and advanced processing capabilities. This can be a limitation for systems with limited processing power or those that cannot accommodate additional computational load. Additionally, machine learning-based approaches require extensive historical data for training, which may not be available or applicable across different motor types and operating conditions.

Methods and systems according to the present disclosure address these challenges by providing a fast and accurate approach for detecting broken rotor bar faults in induction motors using basic mathematical operations without additional sensors. This approach leverages the Park Transform to analyze the three-phase electrical current input to the motor, forming a Park Circle that represents the motor's condition. By quantifying the thickness of this Park Circle, methods and systems of the present disclosure offer an approach to fault detection that is both efficient and easy to implement. The approach requires only the real-time measurement of the three-phase current, eliminating or reducing the need for additional sensors and/or complex data processing. This simplicity allows for integration into existing systems with little or no hardware modification, making it a cost-effective solution for enhancing motor reliability, performance, and/or maintenance.

Accordingly, the present disclosure is generally directed to apparatuses, systems, and methods for detecting broken rotor bar faults in induction motors. As will be explained in further detail below, apparatuses according to some embodiments may include an induction motor, a three-phase electrical current input for driving the induction motor, a sensor for sensing electrical current input values at the three-phase electrical current input, and a processor operatively coupled to the sensor. The processor may be configured to apply a Park transform to electrical current input values received from the sensor during a time period to form a Park circle, determine a thickness of the Park circle, and identify a broken rotor bar fault when the thickness exceeds a predetermined threshold. In some embodiments, the apparatus may form multiple Park circles from data obtained during multiple respective time periods. The multiple Park circles may be analyzed to determine their thicknesses and a broken rotor bar fault may be identified when the thickness of at least one of the Park circles exceeds the predetermined threshold, or when the thicknesses trend or jump upward. Some implementations of apparatuses and methods of the present disclosure may be able to periodically or continuously monitor the operation of induction motors to identify broken rotor bar faults. In some examples, this analysis may be performed using only input electrical current values, which may be obtained in a non-invasive way (e.g., from a sensor coupled to the three-phase electrical current input and not from sensors positioned within the motor itself).

Features from any of the embodiments described herein may be used in combination with one another in accordance with the general principles described herein. These and other embodiments, features, and advantages will be more fully understood upon reading the following detailed description in conjunction with the accompanying drawings and claims.

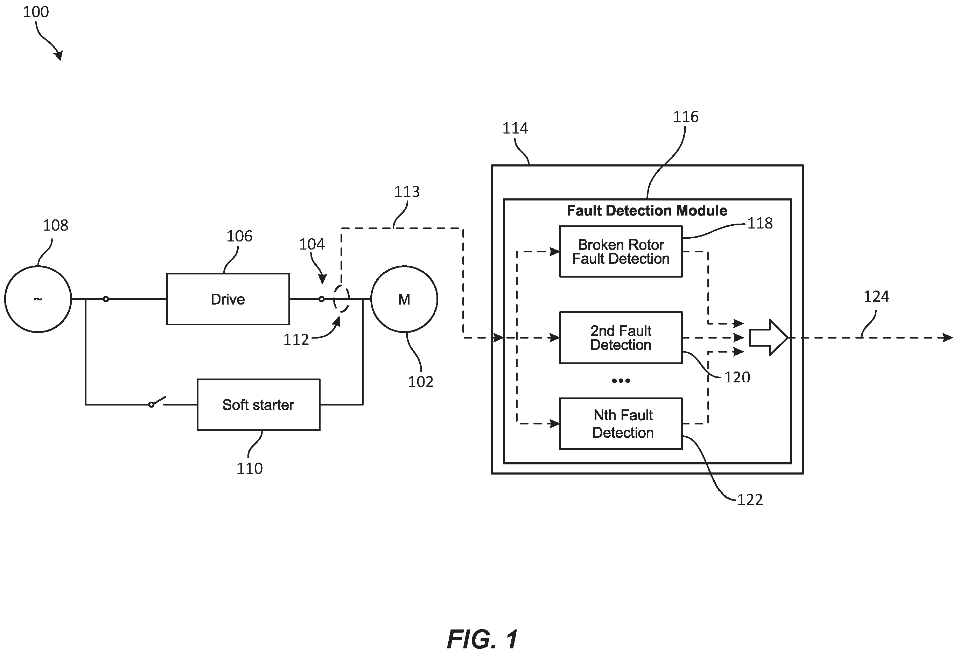

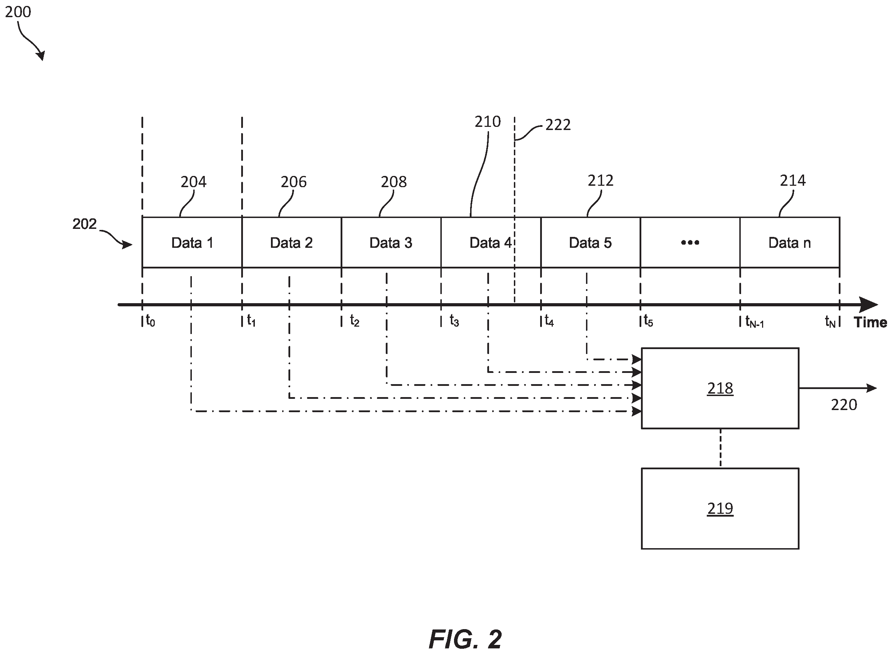

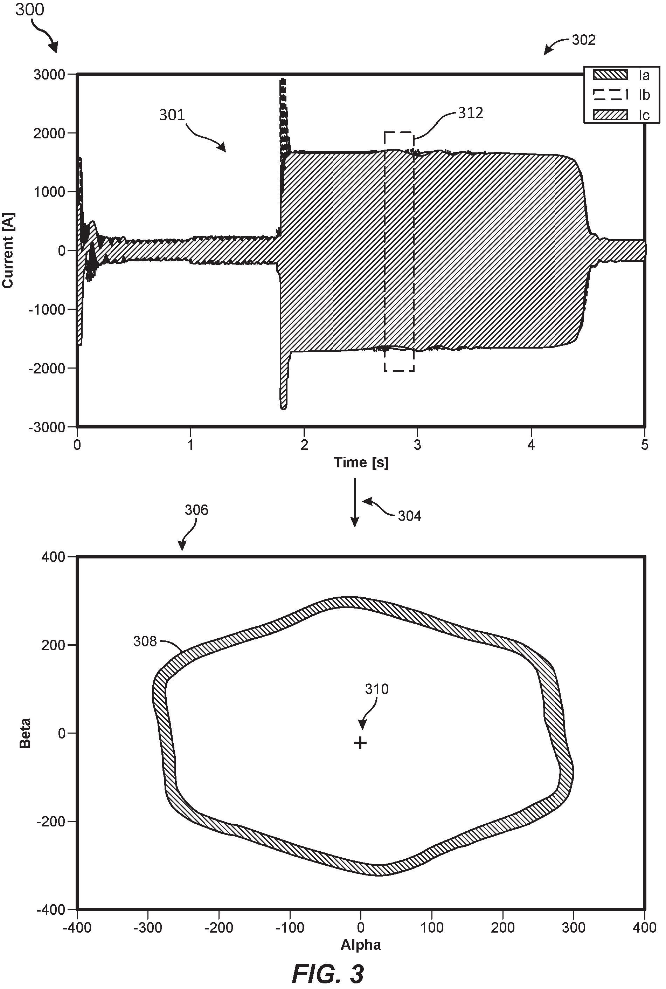

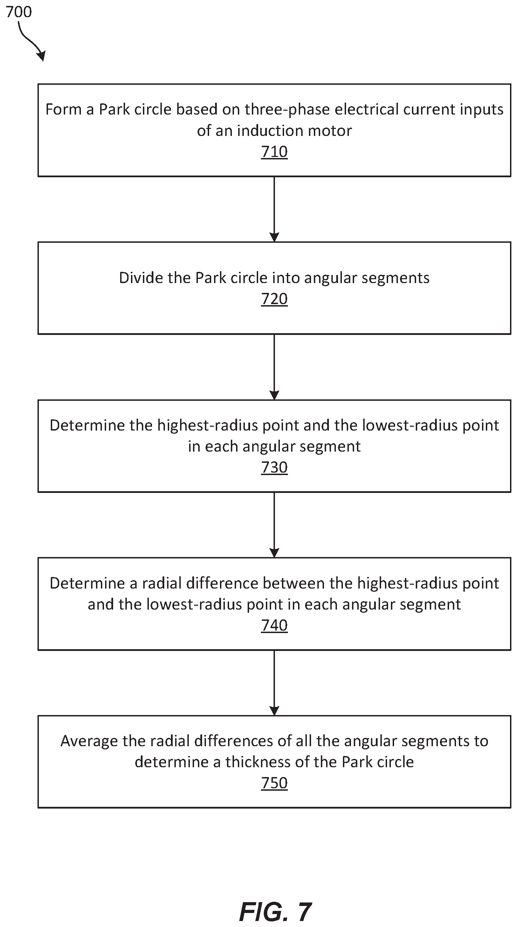

The following will provide, with reference to FIG. 1, a detailed description of an apparatus for detecting broken rotor bar faults in induction motors according to embodiments of the present disclosure. With reference to FIG. 2, the following will provide a detailed description of processing a sequence of data batched by a broken rotor bar fault detection module according to embodiments of the present disclosure. With reference to FIGS. 3-6, the following will provide detailed descriptions of generating and analyzing Park circles to identify broken rotor bar faults in induction motors according to embodiments of the present disclosure. With reference to FIGS. 7-9, detailed descriptions of methods for analyzing Park circles and detecting broken rotor bar faults in induction motors will then be provided.

FIG. 1 is a block diagram illustrating an apparatus 100 for detecting broken rotor bar faults in induction motors, according to at least one embodiment of the present disclosure.

The apparatus 100 represents a comprehensive system designed for detecting broken rotor bar faults in induction motors. The apparatus 100 integrates various components to facilitate the detection process. The apparatus 100 includes an induction motor 102, which serves as a primary component driven by a three-phase electrical current input 104. The induction motor 102 may be configured to convert electrical energy (e.g., from the three-phase electrical current input 104) into mechanical energy through electromagnetic induction, such as for driving industrial machinery and/or equipment. The three-phase electrical current input 104 may be configured to supply power to the induction motor 102, supporting its operation under various load conditions. By way of example and not limitation, the induction motor 102 may be a three-phase squirrel cage motor or a motor with a wound rotor used in an industrial application. During operation, a stator winding of the induction motor 102 may create a rotating magnetic field that induces a current in a rotor. This induced current may generate a magnetic field in the rotor, which may interact with the stator's magnetic field, causing the rotor to turn.

A drive 106 may be connected to the three-phase electrical current input 104 for controlling the power supplied to the induction motor 102. The drive 106 may regulate the voltage and frequency of the three-phase electrical current input 104. This regulation may maintain operational stability of the induction motor 102. An electrical source 108 may be coupled to the drive 106 to supply power to the drive 106 and ultimately to the induction motor 102. The electrical source 108 may be configured to provide a consistent supply of electricity for continuous operation of the apparatus 100, including the induction motor 102.

A starter 110, also referred to as a soft starter, may be connected to the electrical source 108 and the drive 106. The starter 110 may facilitate the gradual increase of voltage to the induction motor 102 during startup, which may reduce mechanical stress and electrical surges. The starter 110 may prolong the lifespan of the motor and may reduce a risk of faults during initial phases of operation.

A current sensor 112 may be positioned to sense the electrical current input values at the three-phase electrical current input 104. The current sensor 112 may provide real-time data 113 indicative of the electrical current flowing into the induction motor 102, which may be used in a fault detection process as explained further below. In some embodiments, the current sensor 112 may be or include one or more Hall effect sensors or current transformers used to measure the electrical current flowing into the induction motor 102. The current sensor 112 can be configured to measure the input electrical current non-invasively, to not interfere with operation of the induction motor 102.

A processor 114 may be operatively coupled to the current sensor 112. The processor 114 may be configured to receive, from the current sensor 112, the data 113 indicative of the sensed electrical current input values. The processor 114 may include a fault detection module 116, which may be configured to detect a broken rotor bar of the induction motor 102 using a broken rotor bar fault detection module 118. In some examples, the fault detection module 116 may include additional fault detection modules, such as a second fault detection module 120 and an Nth fault detection module 122. For example, the second fault detection module 120 may be configured to detect a second fault different from a broken rotor bar fault. Likewise, the Nth fault detection module 122 may be configured to detect an Nth fault different from a broken rotor bar fault and from the second fault. The fault detection module 116 of the processor 114 may include any number of modules for detecting any corresponding number of fault types.

As explained in additional detail below, the broken rotor bar fault detection module 118 of the processor 114 may be configured to apply a Park transform to first electrical current input values obtained by the current sensor 112 during multiple time periods to form multiple respective Park circles. The broken rotor bar fault detection module 118 may determine a thickness of each Park circle. The processor 114 (e.g., the broken rotor bar fault detection module 118 of the processor 114) may identify a broken rotor bar fault when the thickness of a Park circle exceeds a predetermined threshold and/or trends or jumps upward.

When a broken rotor bar fault, or another type of fault, is identified by the fault detection module 116, a fault alarm 124 may be generated. The fault alarm 124 may serve as an alert to notify a user of detected faults and to identify such faults. The fault alarm 124 can send warning signals to the user and/or activate automatic protection devices or procedures, facilitating timely intervention and potentially preventing further damage to the induction motor 102 and/or a system including the induction motor 102.

FIG. 2 is a schematic block diagram 200 illustrating the sequence of data batches 202 processed by a broken rotor bar fault detection module 218, according to at least one embodiment of the present disclosure. The data batches 202 can represent sequential sets of electrical current input values applied to an induction motor (e.g., the induction motor 102 of FIG. 1, such as from the current sensor 112) collected over various time segments. These data batches 202 may be used for real-time monitoring and analysis

First electrical current input values 204 can be collected during the initial time period from initial time t₀ to first time t₁. These first electrical current input values 204 may be used by the broken rotor bar fault detection module 218 to form a first Park circle. The formation and analysis of Park circles are described in further detail below, such as with reference to FIGS. 3-6.

Second electrical current input values 206, gathered during a time period from first time t₁ to second time t₂, contribute to forming a second Park circle by the broken rotor bar fault detection module 218. Likewise, third electrical current input values 208, collected during a third time period from second time t₂ to third time t₃, may be used by the broken rotor bar fault detection module 218 to form a third Park circle. Fourth electrical current input values 210, collected during a fourth time period from third time t₃ to fourth time t₄, may be used by the broken rotor bar fault detection module 218 to form a fourth Park circle. Fifth electrical current input values 212, collected during a fifth time period from fourth time t₄ to fifth time t₅, may be used by the broken rotor bar fault detection module 218 to form a fifth Park circle. Such sampling of electrical current input values during sequential time periods may continue until Nth electrical current input values 214 are collected during an Nth time period between time t_{N-1} and time t_{N}. This process may form a plurality of data batches 202 for processing and analysis (e.g., substantially continuous analysis) by the broken rotor bar fault detection module 218.

In some examples, instructions for detecting broken rotor bar faults may be stored in memory 219 operably coupled to the broken rotor bar fault detection module 218. The memory 219 may also be used by the broken rotor bar fault detection module 218 to store at least some of the data batches 202 and/or data analysis results of the broken rotor bar fault detection module 218, such as for comparison to subsequent data analysis results.

The sequential collection and analysis of the data batches 202 may allow for the detection of trends and/or changes in thickness of the Park circles generated by the broken rotor bar fault detection module 218, as described further below. When a change in thickness from a baseline beyond a predetermined threshold or an upward trend in thicknesses occurs, the broken rotor bar fault detection module 218 may identify a fault and communicate a fault alarm 220 to a user and/or to an automatic protection device or procedure.

For example, if a fault 222 (e.g., a broken rotor bar) occurs during the fourth time period (e.g., after the third time t₃ and before the fourth time t₄), some of the data from the fourth electrical current input values 210, when analyzed by the broken rotor bar fault detection module 218, may start to indicate the fault 222 occurred. Since the fourth electrical current input values 210 also include some data during healthy operation (e.g., prior to the fault 222), a change in thickness of a corresponding Park circle may not be sufficient (e.g., may be below a threshold) for the broken rotor bar fault detection module 218 to identify the fault 222. However, the data from the fifth electrical current input values 212 may all be collected during the fifth time period when the motor is operating with in a faulty condition. Accordingly, analysis of the fifth electrical current input values 212 may result in a sufficient change in thickness of a corresponding Park circle to exceed a predetermined threshold and to indicate the fault 222.

In some examples, the sampling of the electrical current input values may be performed at a sampling frequency complying to the Nyquist criterion (e.g., at least twice the induction motor's operating frequency), such as to enable the data batches 202 to each include sufficient data for detection of broken rotor bar faults. Additionally, each time period may include at least a sufficient time to complete one full electricity cycle of the induction motor to generate a full Park circle with sufficient data for analysis and fault detection.

The broken rotor bar fault detection module 218 can receive and analyze the data batches to identify significant changes in the Park circle thicknesses. The broken rotor bar fault detection module 218 may be responsible for detecting broken rotor bar faults by comparing the thickness of Park circles over time. For example, the generation and analysis of Park circles to identify broken rotor bar faults is described below with reference to FIGS. 3-6.

In some embodiments, forming Park circles may not involve the actual visual depiction of Park circles. Rather, forming a Park circle may refer to applying the Park transform to input current values and storing the results of the Park transform in memory (e.g., in a database) without plotting or otherwise visually depicting the resulting Park circle. Determining the thickness of the Park circle may, in some examples, simply refer to analyzing this data as explained herein.

FIG. 3 is a diagram 300 illustrating the transformation of three-phase current data 301 into a Park circle 308 using a Park transform 304, according to at least one embodiment of the present disclosure. The diagram 300 includes a first plot 302 of the three-phase current data 301 and a second plot 306 of the Park circle 308 obtained by applying the Park transform 304 to the three-phase current data 301.

In the first plot 302, the three-phase current data 301 is depicted, showing a first phase current *Iₐ*, a second phase current *I_{b},* and a third phase current *I_{c}.* These currents are the input electrical values that drive an induction motor. The Park transform 304 is applied to these three-phase current inputs to convert them into a two-dimensional representation in an alpha-beta coordinate system, as shown in the second plot 306.

The Park transform 304 processes the three-phase current data by calculating a direct component *I_{d}* and a quadrature component *I_{q}* from the first phase current *Iₐ,* the second phase current *I_{b},* and the third phase current *I_{c}*.The Park transform 304 may be performed using the following equations (1) and (2): ${I}_{d} = \frac{\sqrt{2}}{\sqrt{3}} {I}_{a} - \frac{1}{\sqrt{6}} {I}_{b} - \frac{1}{\sqrt{6}} {I}_{c}$ (1) ${I}_{q} = \frac{1}{\sqrt{2}} {I}_{b} - \frac{1}{\sqrt{2}} {I}_{c}$ (2)

These components may then be combined into a complex number *I = I_{d} + jI_{q},* where j is the imaginary unit (i.e., the square root of negative one). This complex representation allows the three-phase current data 301 (or a portion thereof) to be plotted in the alpha-beta plane, with the direct component *I_{d}* (real part) on the alpha axis and the quadrature component *I_{q}* (imaginary part) on the beta axis.

The Park circle 308 may be generated based on a data set of the three-phase current data 301 collected during a time segment 312, as shown in the first plot 302. The second plot 306 illustrates the Park circle 308 formed around an origin 310 in an alpha-beta coordinate system. The origin 310 serves as a reference point for measuring distances to points forming the Park circle. The Park circle 308 represents the motor's condition, with characteristics of the Park circle, such as thickness, providing insights into the motor's health. Variations in the thickness of Park circles formed over time can indicate faults, such as broken rotor bars, allowing for fault detection. For example, respective Park circles like the Park circle 308 may be formed for various time segments before and/or after the time segment 312 for substantially continuous monitoring of the induction motor.

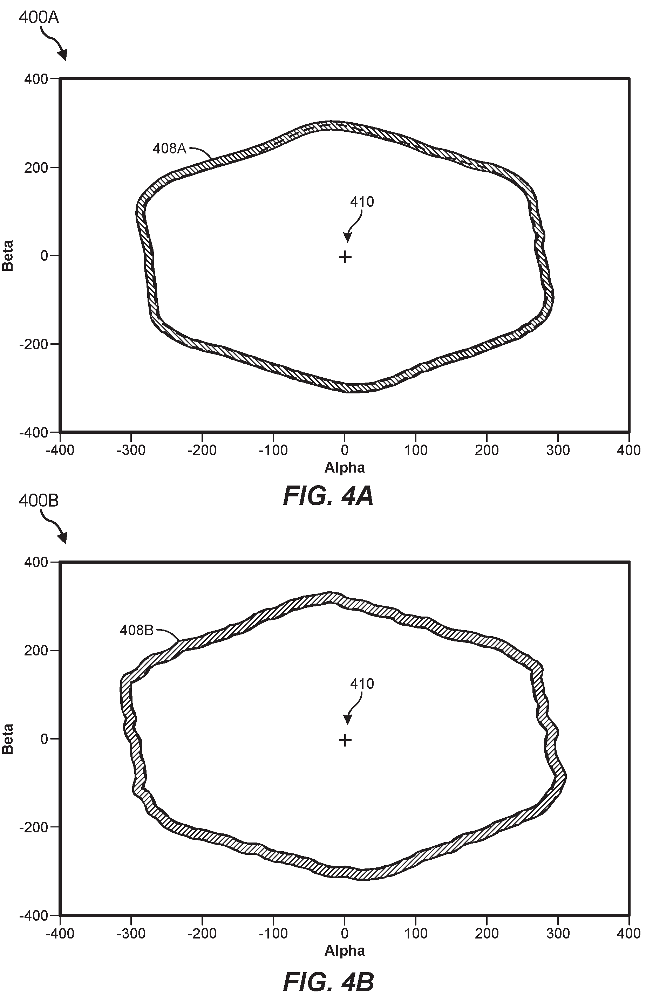

FIG. 4A is a first plot 400A illustrating a first Park circle 408A generated during healthy operation of an induction motor, according to at least one embodiment of the present disclosure. FIG. 4B is a second plot 400B illustrating a second Park circle 408B generated during faulty operation of an induction motor, according to at least one embodiment of the present disclosure.

The first Park circle 408A of the first plot 400A was formed by applying a Park transform (as described above with reference to FIG. 3) to three-phase current data obtained from a current sensor at an electrical input to the induction motor. The first Park circle 408A is depicted in an alpha-beta coordinate system, where the alpha axis represents the real component and the beta axis represents the imaginary component of the transformed current data.

As illustrated in FIG. 4A, the first Park circle 408A in the first plot 400A may have a generally circular shape around an origin 410, which indicates a healthy operational condition of the induction motor. The thickness of the first Park circle 408A reflects the stability and balance of the induction motor's operation. When the induction motor operates in a healthy state, the resulting first Park circle 408A maintains a substantially consistent thickness below a predetermined threshold, suggesting that the motor is functioning without any significant faults or anomalies. For example, the predetermined threshold thickness may depend on one or more factors, such as historical data, motor type, motor size, operating conditions (e.g., load and/or environmental conditions), etc.

Referring to FIG. 4B, the second plot 400B depicts the second Park circle in an alpha-beta coordinate system, where the alpha axis represents the real component and the beta axis represents the imaginary component of the transformed current data. The second Park circle 408B in the second plot 400B may exhibit a distorted circular shape around the origin 410, which may indicate the presence of a broken rotor bar fault in the induction motor. An increased thickness of the second Park circle 408B over the predetermined threshold may reflect the instability and imbalance in the induction motor's operation due to a broken rotor bar.

In comparison to the first Park circle 408A, which was generated during healthy operation and maintains a substantially consistent thickness indicative of stable motor performance, the second Park circle 408B may show increased average thickness and/or thickness irregularity. This comparison of the first Park circle 408A with the second Park circle 408B may serve as an indicator of deterioration in motor health due to the broken rotor bar fault. The analysis of these Park circles may provide insights into the motor's operational state, allowing for timely detection and intervention to address the identified fault.

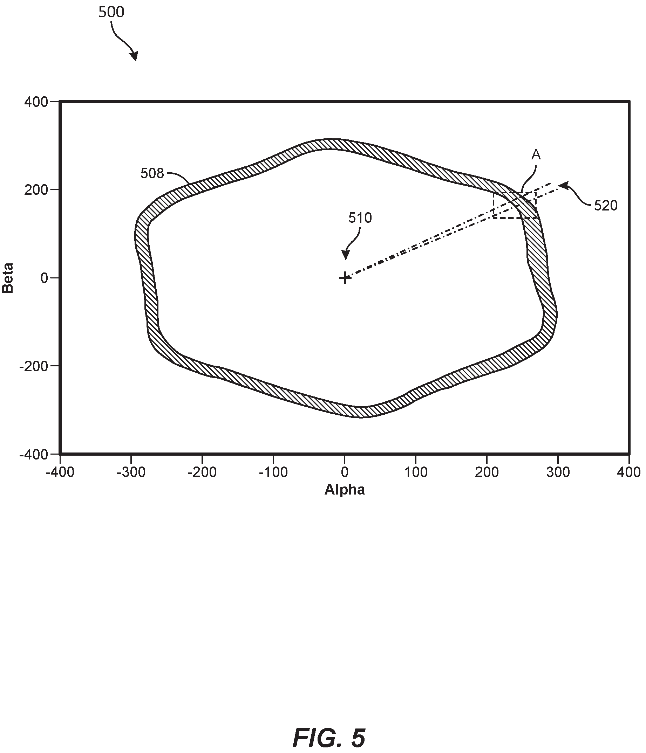

FIG. 5 is a plot 500 illustrating a Park circle 508 and an angular segment 520 used for detecting broken rotor bar faults in induction motors, according to at least one embodiment of the present disclosure.

The plot 500 in FIG. 5 may show the Park circle 508, which can play a role in the detection of broken rotor bar faults in induction motors. The plot 500 may visually depict the transformation of three-phase current data into a two-dimensional alpha-beta coordinate system using the Park transform, as explained above. This transformation results in the formation of the Park circle 508, which can be analyzed to determine the motor's operational condition.

The Park circle 508 may be formed by plotting the alpha and beta components of the transformed three-phase current data obtained during a time period, as summarized above. The Park circle 508 may be divided into a plurality of angular segments 520 (e.g., equally spaced angular segments) to facilitate detailed analysis of the characteristics of the motor's condition. The Park circle 508 may be divided into any number of angular segments 520 to help determine an average thickness of the Park circle 508, such as ten angular segments 520, fifteen angular segments 520, twenty-four angular segments 520, thirty angular segments 520, thirty-six angular segments 520, forty-five angular segments 520, sixty angular segments 520, seventy-two angular segments 520, ninety angular segments 520, one hundred twenty angular segments 520, one hundred eighty angular segments 520, three hundred sixty angular segments 520, seven hundred twenty angular segments 520, etc. Other quantities of angular segments, including those that may result in non-integer angles for each angular segment, may also be used.

As described below, the thickness of each angular segment 520 may be determined, and then the thicknesses of all the angular segments 520 may be averaged to determine an average thickness of the Park circle 508. A single one of the angular segments 520 is illustrated in the plot 500 and described below, but the following discussion and analysis applies to each angular segment 520 of the Park circle 508.

The angular segment 520 is a specific portion of the Park circle 508, defined by an angle in the alpha-beta coordinate system. The angular segment 520 can be used to analyze the radial differences (e.g., a difference between the radius) of points within the Park circle 508. By dividing the Park circle 508 into angular segments 520, the system can determine the point with the greatest radius and the point with the smallest radius within each angular segment 520.

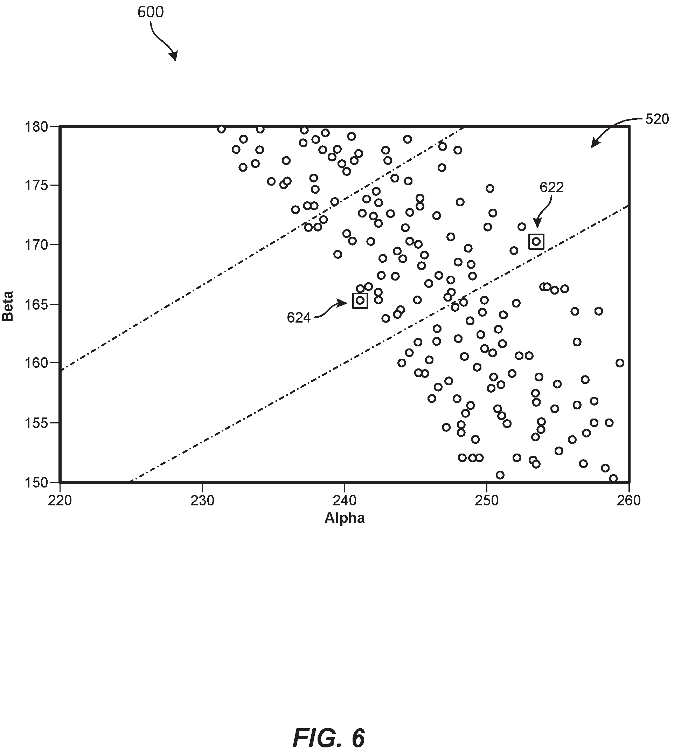

The plot 600 in FIG. 6 provides a detailed view of the angular segment 520 within dashed box A of FIG. 5. The plot 600 illustrates a highest-radius point 622 and a lowest-radius point 624 of the Park circle 508 within the angular segment 520. A system (e.g., the broken rotor bar fault detection module 118 and/or the broken rotor fault detection module 218) may determine which of all the points within the angular segment 520 is the highest-radius point 622 (e.g., a point with a maximum distance from an origin 510 of the Park circle 508) and which is the lowest-radius point 624 (e.g., a point with a minimum distance from the origin 510 of the Park circle 508). The highest-radius point 622 and the lowest-radius point 624 may be determined by comparing the distances of all points within the angular segment 520 from the origin 510 and respectively selecting the points with the highest and lowest distances. The radius of the lowest-radius point 624 may be subtracted from the radius of the highest-radius point 622 to determine a thickness of the Park circle 508 at the angular segment 520.

In some examples, the distances to the origin 510 of all points within the angular segment 520 may be stored in memory and compared to identify the highest-radius point and the lowest-radius point. The memory may be updated with new distance calculations as additional data is received from the current sensor and as the Park transform is applied to this additional data to generate points of the Park circle. This process of storing the points and updating the distance calculations may improve a speed of identifying a broken rotor bar fault.

The same process may be performed for all angular segments 520 of the Park circle 508, and the resulting thicknesses may be averaged to determine the average thickness of the Park circle 508 for the time period when data was collected and transformed using the Park transform to generate the Park circle 508. This average thickness may be compared with a predetermined threshold of healthy operation of the induction motor and/or with thicknesses obtained from prior time periods. If the average thickness trends upwards and/or increases beyond the predetermined threshold, then a broken rotor bar fault may be identified.

In additional embodiments, the determination of the thickness of the Park circle 508 may be performed by, for each angular segment 520, selecting an external point (e.g., the highest-radius point 622) having a maximum distance from the origin 510 and an internal point (e.g., the lowest-radius point 624) having a minimum distance from the origin 510. An equivalent external radius may be calculated as an average of the maximum distances from all of the angular segments 520. An equivalent internal radius may be calculated as an average of the minimum distances from all of the angular segments 520. The thickness of the Park circle may be determined by subtracting the equivalent internal radius from the equivalent external radius.

FIG. 7 is a flow chart diagram illustrating a method 700 for determining a thickness of a Park circle obtained from operation of an induction motor, according to at least one embodiment of the present disclosure. For example, the method 700 may be implemented by the processor 114 operatively coupled to the current sensor 112 that senses electrical current input values (e.g., three-phase electrical current) applied for driving the induction motor 102.

At operation 710, a Park circle may be formed based on three-phase electrical current inputs of the induction motor. Operation 710 may be performed in a variety of ways. For example, three-phase electrical current input values may be sensed by a current sensor and sent to a broken rotor bar fault determination module of a processor, as described above. A Park transform may be performed on the electrical current input values to convert these values into a two-dimensional representation in an alpha-beta coordinate system to form the Park circle. As noted above, in some embodiments, sampling of the electrical current input values may be performed at a frequency complying to the Nyquist criterion. In some examples, the sampling may be performed for a time period to complete at least one full electricity cycle of the induction motor. The formation of the Park circle at operation 710 may be performed for data collected during the time period.

At operation 720, the Park circle may be divided into angular. Operation 720 may be performed in a variety of ways. For example, the Park circle may be divided into a plurality of substantially equal angular segments, such as ten angular segments, fifteen angular segments, twenty-four angular segments, thirty angular segments, thirty-six angular segments, forty-five angular segments, sixty angular segments, seventy-two angular segments, ninety angular segments, one hundred twenty angular segments, one hundred eighty angular segments, three hundred sixty angular segments, seven hundred twenty angular segments, etc. Other quantities of angular segments, including those that may result in non-integer angles for each angular segment, may also be used. By way of example and not limitation, each of the angular segments may be a segment of between 0.01 degree and 10 degrees, such as 0.01 degree, 0.1 degree, 0.25 degree, 0.5 degree, 1 degree, 2 degrees, 5 degrees, 10 degrees, etc. A set of multiple points defining the Park circle may be present within each angular segment.

At operation 730, a highest-radius point (i.e., a point with a largest distance from an origin) and a lowest-radius point (i.e., a point with a smallest distance from the origin) in each angular segment may be determined. Operation 730 may be performed in a variety of ways. For example, operation 730 may involve calculating the distance of each point within the segment from the origin of the alpha-beta coordinate system used to form the Park circle, and selecting the points with the maximum and minimum distances as the highest-radius point and lowest-radius point, respectively.

At operation 740, a radial difference between the highest-radius point and the lowest-radius point in each angular segment may be determined. Operation 740 may be performed in a variety of ways. For example, this radial difference may be calculated by subtracting a radius of the lowest-radius point from a radius of the highest-radius point within each angular segment.

At operation 750, the radial differences of all the angular segments may be averaged to determine a thickness (e.g., an average thickness) of the Park circle. In some respects, this average thickness may provide an indication of the induction motor's operational condition, wherein variations in thickness (e.g., thicknesses that trend upwards, thicknesses that exceed a predetermined threshold, etc.) may indicate a broken rotor bar fault.

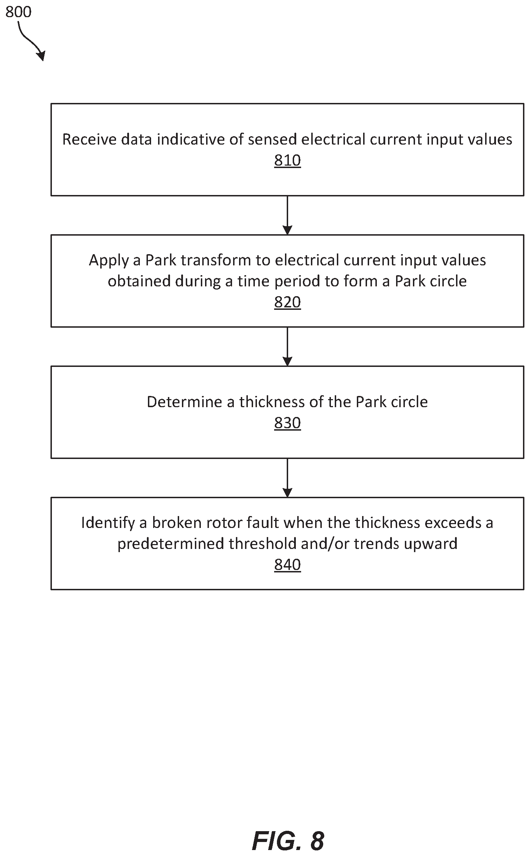

FIG. 8 is a flow diagram illustrating a method 800 for detecting broken rotor bar faults in induction motors, according to at least one embodiment of the present disclosure.

At operation 810, data indicative of sensed electrical current input values for an induction motor may be received, such as by a processor. Operation 810 may be performed in a variety of ways. For example, a sensor for sensing electrical current input values at a three-phase electrical current input for driving the induction motor may generate the data to be received by the processor.

At operation 820, a Park transform may be applied to electrical current input values obtained during a time period to form a Park circle. Operation 820 may be performed in a variety of ways. For example, the electrical current input values may be sensed by a current sensor and transmitted to a processor configured with a broken rotor bar fault determination module. The Park transform may be executed on the electrical current input values to convert them into a two-dimensional representation in an alpha-beta coordinate system, thereby forming the Park circle.

At operation 830, a thickness of the Park circle may be determined. Operation 830 may be performed in a variety of ways. For example, the Park circle may be divided into angular segments, and the radial differences between a highest-radius point and a lowest-radius point within each segment may be analyzed, such as in the manner described above with reference to the method 700 of FIG. 7. The thickness of the Park circle may be calculated by averaging these radial differences. In additional examples, the maximum radius of each of the highest-radius points in all of the angular segments may be averaged to determine an external radius of the Park circle and the minimum radius of each of the lowest-radius points in all of the angular segments may be averaged to determine an internal radius of the Park circle. The thickness of the Park circle may be determined by subtracting the internal radius from the external radius.

At operation 840, a broken rotor bar fault may be identified when the thickness exceeds a predetermined threshold and/or trends upward. Operation 860 may be performed in a variety of ways. In some embodiments, the predetermined threshold that indicates a broken rotor bar fault condition may be set, such as based on historical data, motor type, motor size, motor operating conditions (e.g., load and/or environmental conditions), etc. The thickness surpassing this threshold may suggest that a broken rotor bar fault has occurred, prompting an alert for further investigation or intervention to address the issue. In additional embodiments, multiple Park circles may be formed based on sensed electrical current input values over multiple respective time periods. The thickness of each of the Park circles may be determined, and a broken rotor bar fault may be identified with the thicknesses jump or trend upward.

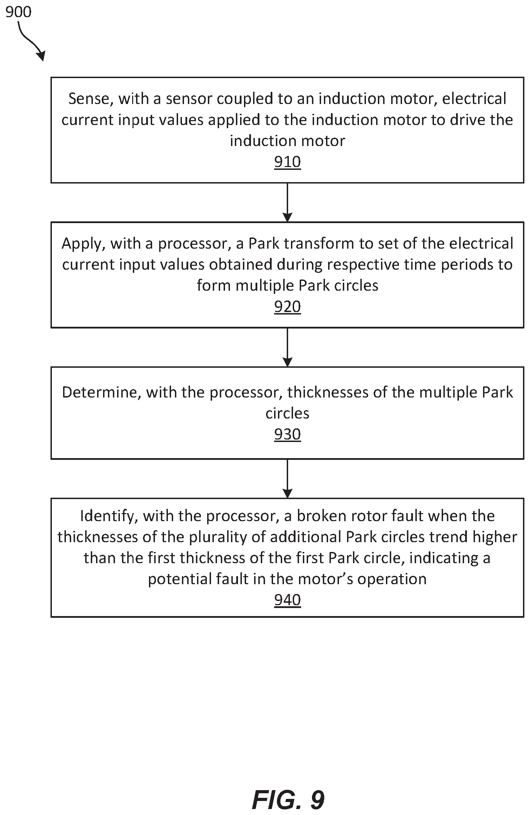

FIG. 9 is a flow diagram illustrating a method 900 for detecting broken rotor bar faults in induction motors, according to at least one additional embodiment of the present disclosure.

At operation 910, electrical current input values may be sensed by a sensor coupled to an induction motor. Operation 910 may be performed in a variety of ways. For example, the sensor may be configured to measure the three-phase electrical current input values applied to drive the induction motor. These sensed values can be transmitted to a processor for further analysis, as described below in relation to subsequent operations.

At operation 920, a Park transform may be applied to sets of the electrical current input values obtained during respective time periods to form multiple Park circles. Operation 920 may be performed in a variety of ways. For example, the processor may execute the Park transform on the sets of sensed electrical current input values to convert them into two-dimensional representations in an alpha-beta coordinate system. This transformation may result in the formation of the multiple Park circles, which may be used to assess the motor's operational condition. The sampling of electrical current input values may be performed at a frequency complying to the Nyquist criterion to ensure sufficient data collection during each of the time periods. Additionally, the time periods may each be longer than at least one electricity cycle of the induction motor.

At operation 930, thicknesses of the multiple Park circles may be determined. Operation 930 may be performed in a variety of ways. For example, the processor may analyze the radial characteristics of the Park circles by dividing each Park circle into angular segments and calculating the radial differences between a highest-radius point and a lowest-radius point within each angular segment. The thickness of each Park circle may be calculated by averaging these radial differences.

At operation 940, a broken rotor barfault may be identified with the processor when the thicknesses of the multiple Park circles trend upward. Operation 940 may be performed in a variety of ways, such as by comparing the thickness measurements of the Park circles over time. If the thicknesses of the Park circles exhibit a trend of increasing, such as beyond a predetermined threshold, this trend may suggest that a broken rotor bar fault has occurred, prompting further investigation or intervention to address the issue.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various example methods described and/or illustrated herein may also omit one or more of the steps described or illustrated herein or include additional steps in addition to those disclosed.

Accordingly, the present disclosure includes apparatuses and methods that may provide one or more improvements over conventional motors. For example, the disclosed methods may enable efficient fault detection using real-time current measurements, enhancing motor reliability and performance. Applications include industrial settings where induction motors are common, providing a cost-effective solution for maintenance and operational efficiency. Apparatuses of the present disclosure may function by converting three-phase current into alpha-beta coordinates using a Park transform to form a generally circular pattern, and analyzing thickness variations of the patterns to detect faults.

The following example embodiments are also included in the present disclosure.

Example 1. An apparatus, including: an induction motor; a three-phase electrical current input for driving the induction motor; a sensor for sensing electrical current input values at the three-phase electrical current input; and a processor operatively coupled to the sensor, the processor configured to: receive data indicative of the sensed electrical current input values from the sensor; apply a Park transform to electrical current input values obtained during a time period to form a Park circle; determine a thickness of the Park circle; and identify a broken rotor bar fault when the thickness exceeds a predetermined threshold.

Example 2. The apparatus of Example 1, wherein: the processor determining the thickness of the Park circle includes: dividing the Park circle into angular segments; determining a radial difference between a highest-radius point and a lowest-radius point within each of the angular segments; and determining an average of the radial differences between the highest-radius points and lowest-radius points of all the angular segments.

Example 3. The apparatus of Example 2, wherein each of the angular segments is a segment of between 0.01 degree and 10 degrees.

Example 4. The apparatus of Example 2 or Example 3, wherein the processor determining the highest-radius point within each of the angular segments includes: calculating a distance of each point in the angular segment from an origin; and selecting a point with a maximum distance as the highest-radius point.

Example 5. The apparatus of any one of Examples 2 through 4, wherein the processor determining the lowest-radius point within each of the angular segments includes: calculating a distance of each point in the angular segment from an origin; and selecting a point with a minimum distance as the lowest-radius point.

Example 6. The apparatus of any one of Examples 2 through 5, wherein the processor is further configured to, for each of the angular segments: store distances to an origin of all points within the angular segment in a memory; compare the stored distances to identify the highest-radius point and the lowest-radius point; and update the memory with new distance calculations as additional data points are received.

Example 7. The apparatus of any one of Examples 1 through 6, wherein: the processor determining the thickness of the Park circle includes: dividing the Park circle into a plurality of evenly spaced angular segments; for each angular segment, selecting an external point having a maximum distance from an origin and an internal point having a minimum distance from the origin; calculating an equivalent external radius as an average of the maximum distances and an equivalent internal radius as an average of the minimum distances across all the angular segments; and determining the thickness of the Park circle by subtracting the equivalent internal radius from the equivalent external radius.

Example 8. The apparatus of any one of Examples 1 through 7, wherein the processor applying the Park transform to the electrical current input values to form the Park circle includes: converting the three-phase electrical current input values obtained during the time period into alpha-beta coordinates; and plotting the alpha-beta coordinates in an alpha-beta plane to form a generally circular pattern of the alpha-beta coordinates.

Example 9. The apparatus of any one of Examples 1 through 8, wherein the processor is further configured to sample the three-phase electrical current input values at a sampling frequency at least twice an operating frequency of the induction motor to obtain sufficient data points for forming the Park circle.

Example 10. The apparatus of any one of Examples 1 through 9, wherein the processor applying the Park transform to the electrical current input values to form the Park circle includes calculating a direct component *I_{d}* and a quadrature component *I_{q}* from the electrical current input values and representing the three-phase current in an alpha-beta plane using the following equations: ${I}_{d} = \frac{\sqrt{2}}{\sqrt{3}} {I}_{a} - \frac{1}{\sqrt{6}} {I}_{b} - \frac{1}{\sqrt{6}} {I}_{c} , {I}_{q} = \frac{1}{\sqrt{2}} {I}_{b} - \frac{1}{\sqrt{2}} {I}_{c}$, and, *I* = *I_{d} + jI_{q}* , where: *Iₐ* is a first current in a first phase of the electrical current input values, *I_{b}* is a second current in a second phase of the electrical current input values, *I_{c}* is a third current in a third phase of the electrical current input values,j is an imaginary unit equal to $\sqrt{- 1}$, and *I* is a complex number to be plotted in the alpha-beta plane as (*I_{d}, I_{q}*) to form the Park circle.

Example 11. The apparatus of any one of Examples 1 through 10, wherein the time period includes at least a sufficient time to complete one full electricity cycle of the induction motor.

Example 12. A method for detecting broken rotor bar faults in induction motors, including: sensing, with a sensor coupled to an induction motor, electrical current input values applied to the induction motor to drive the induction motor; applying, with a processor, a Park transform to sets of the electrical current input values obtained during respective time periods to form multiple Park circles; determining, with the processor, thicknesses of the multiple Park circles; and identifying, with the processor, a broken rotor bar fault when the thicknesses of the multiple Park circles trend upward.

Example 13. The method of Example 12, wherein determining the thicknesses of the multiple Park circles includes dividing the respective Park circles into angular segments and calculating a radial difference between a highest-radius point and a lowest-radius point within each angular segment.

Example 14. The method of Example 13, further including: storing, with the processor in a memory, radial distances of all points of the respective Park circles within each angular segment; comparing, with the processor, the stored radial distances to identify the highest-radius point and the lowest-radius point in each angular segment; and updating, with the processor in the memory, new radial difference calculations as additional electrical current input values are received by the processor.

Example 15. The method of Example 13 or Example 14, wherein determining the thicknesses of the multiple Park circles includes determining an average radial difference between the highest-radius point and the lowest-radius point of all the angular segments of each Park circle of the multiple Park circles.

Example 16. The method of any one of Examples 12 through 15, wherein the time period includes at least a sufficient time to complete one full electricity cycle of the induction motor.

Example 17. The method of any one of Examples 12 through 16, further including sampling the electrical current input values with the sensor at a sampling frequency at least twice an operating frequency of the induction motor to obtain sufficient data points for forming the multiple Park circles.

Example 18. The method of any one of Examples 12 through 17, wherein identifying, with the processor, the broken rotor bar fault includes identifying the broken rotor bar fault when the thicknesses of the multiple Park circles trend upward or exceed a predetermined threshold.

Example 19. The method of any one of Examples 12 through 18, wherein sensing the electrical current input values applied to the induction motor includes sensing three-phase electrical current input values.

Example 20. A non-transitory computer-readable medium storing instructions that, when executed by a processor, cause the processor to perform a method for detecting broken rotor bar faults in induction motors, the method including: sensing electrical current input values applied to an induction motor to drive the induction motor; applying a Park transform to sets of the electrical current input values obtained during respective time periods to form multiple Park circles; determining thicknesses of the multiple Park circles; and identifying a broken rotor bar fault when the thicknesses of the multiple Park circles trend upward or at least one of the thicknesses exceeds a predetermined threshold.

The preceding description has been provided to enable others skilled in the art to best utilize various aspects of the example embodiments disclosed herein. This example description is not intended to be exhaustive or to be limited to any precise form disclosed. Many modifications and variations are possible without departing from the spirit and scope of the present disclosure. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

## Claims

1. An apparatus, comprising:
an induction motor;
a three-phase electrical current input for driving the induction motor;
a sensor for sensing electrical current input values at the three-phase electrical current input;
and
a processor operatively coupled to the sensor, the processor configured to:
receive data indicative of the sensed electrical current input values from the sensor;
apply a Park transform to electrical current input values obtained during a time period to form a Park circle;
determine a thickness of the Park circle; and
identify a broken rotor bar fault when the thickness exceeds a predetermined threshold.

2. The apparatus of claim 1, wherein:
the processor determining the thickness of the Park circle comprises:
dividing the Park circle into angular segments;
determining a radial difference between a highest-radius point and a lowest-radius point within each of the angular segments; and
determining an average of the radial differences between the highest-radius points and lowest-radius points of all the angular segments.

3. The apparatus of claim 2, wherein each of the angular segments is a segment of between 0.01 degree and 10 degrees.

4. The apparatus of claim 2 or 3, wherein the processor determining the highest-radius point within each of the angular segments comprises:
calculating a distance of each point in the angular segment from an origin; and
selecting a point with a maximum distance as the highest-radius point.

5. The apparatus of one of claims 2 to 4, wherein the processor determining the lowest-radius point within each of the angular segments comprises:
calculating a distance of each point in the angular segment from an origin; and
selecting a point with a minimum distance as the lowest-radius point.

6. The apparatus of one of claims 2 to 5, wherein the processor is further configured to, for each of the angular segments:
store distances to an origin of all points within the angular segment in a memory;
compare the stored distances to identify the highest-radius point and the lowest-radius point;
and
update the memory with new distance calculations as additional data points are received.

7. The apparatus of one of the preceding claims, wherein:
the processor determining the thickness of the Park circle comprises:
dividing the Park circle into a plurality of evenly spaced angular segments;
for each angular segment, selecting an external point having a maximum distance from an origin and an internal point having a minimum distance from the origin;
calculating an equivalent external radius as an average of the maximum distances and an equivalent internal radius as an average of the minimum distances across all the angular segments; and
determining the thickness of the Park circle by subtracting the equivalent internal radius from the equivalent external radius.

8. The apparatus of one of the preceding claims, wherein the processor applying the Park transform to the electrical current input values to form the Park circle comprises:
converting the three-phase electrical current input values obtained during the time period into alpha-beta coordinates; and
plotting the alpha-beta coordinates in an alpha-beta plane to form a generally circular pattern of the alpha-beta coordinates.

9. The apparatus of one of the preceding claims, wherein the processor is further configured to sample the three-phase electrical current input values at a sampling frequency at least twice an operating frequency of the induction motor to obtain sufficient data points for forming the Park circle.

10. The apparatus of one of the preceding claims, wherein the processor applying the Park transform to the electrical current input values to form the Park circle comprises calculating a direct component *I_{d}* and a quadrature component *I_{q}* from the electrical current input values and representing the three-phase current in an alpha-beta plane using the following equations: ${I}_{d} = \frac{\sqrt{2}}{\sqrt{3}} {I}_{a} - \frac{1}{\sqrt{6}} {I}_{b} - \frac{1}{\sqrt{6}} {I}_{c} ,$ ${I}_{q} = \frac{1}{\sqrt{2}} {I}_{b} - \frac{1}{\sqrt{2}} {I}_{c} ,$ and $I = {I}_{d} + {jI}_{q} ,$ where:
*Iₐ* is a first current in a first phase of the electrical current input values,
*I_{b}* is a second current in a second phase of the electrical current input values,
*I_{c}* is a third current in a third phase of the electrical current input values,
j is an imaginary unit equal to $\sqrt{- 1}$, and
*I* is a complex number to be plotted in the alpha-beta plane as (*I_{d}, I_{q}*) to form the Park circle.

11. The apparatus of one of the preceding claims, wherein the time period comprises at least a sufficient time to complete one full electricity cycle of the induction motor.

12. A method for detecting broken rotor bar faults in induction motors, comprising:
sensing, with a sensor coupled to an induction motor, electrical current input values applied to the induction motor to drive the induction motor;
applying, with a processor, a Park transform to sets of the electrical current input values obtained during respective time periods to form multiple Park circles;
determining, with the processor, thicknesses of the multiple Park circles; and
identifying, with the processor, a broken rotor bar fault when the thicknesses of the multiple Park circles trend upward.

13. The method of claim 12, wherein determining the thicknesses of the multiple Park circles comprises dividing the respective Park circles into angular segments and calculating a radial difference between a highest-radius point and a lowest-radius point within each angular segment.

14. The method of claim 13, further comprising:
storing, with the processor in a memory, radial distances of all points of the respective Park circles within each angular segment;
comparing, with the processor, the stored radial distances to identify the highest-radius point and the lowest-radius point in each angular segment; and
updating, with the processor in the memory, new radial difference calculations as additional electrical current input values are received by the processor.

15. The method of claim 13 or 14, wherein determining the thicknesses of the multiple Park circles comprises determining an average radial difference between the highest-radius point and the lowest-radius point of all the angular segments of each Park circle of the multiple Park circles.

16. The method of one of claims 12 to 15, wherein the time period comprises at least a sufficient time to complete one full electricity cycle of the induction motor.

17. The method of one of claims 12 to 16, further comprising sampling the electrical current input values with the sensor at a sampling frequency at least twice an operating frequency of the induction motor to obtain sufficient data points for forming the multiple Park circles.

18. The method of one of claims 12 to 17, wherein identifying, with the processor, the broken rotor bar fault comprises identifying the broken rotor bar fault when the thicknesses of the multiple Park circles trend upward or exceed a predetermined threshold.

19. The method of one of claims 12 to 18, wherein sensing the electrical current input values applied to the induction motor comprises sensing three-phase electrical current input values.

20. A non-transitory computer-readable medium storing instructions that, when executed by a processor, cause the processor to perform a method for detecting broken rotor bar faults in induction motors, the method comprising:
sensing electrical current input values applied to an induction motor to drive the induction motor;
applying a Park transform to sets of the electrical current input values obtained during respective time periods to form multiple Park circles;
determining thicknesses of the multiple Park circles; and
identifying a broken rotor bar fault when the thicknesses of the multiple Park circles trend upward or at least one of the thicknesses exceeds a predetermined threshold.
